# EUROPEAN PATENT APPLICATION

(11) **EP 2 657 378 A1**
(43) Date of publication of application: **30.10.2013**
(21) Application number: 11850318.4
(22) Date of filing: 07.01.2011
(51) Int. Cl.: C30B 29/38

(54) **METHOD AND DEVICE FOR MANUFACTURING SELF-SUPPORTING GALLIUM NITRIDE (GaN) SUBSTRATE**

(30) Priority: 21.12.2010 JP 2010284901
(71) Applicant: A.E.Tech Corporation, Tokyo 100-0054 (JP)
(72) Inventor: GOTO Hideki, Tokyo 100-0054 (JP)
(74) Representative: Dearden, Anthony James
(86) International application number: PCT/JP2011/050175
(87) International publication number: WO 2012/086212

(57) **Abstract**

It is to suppress abnormal growth of GaN crystals around edge ends of a seed substrate. ] A susceptor is provided that has a pocket section in which a seed substrate is fixed, and a sub-susceptor provided between the susceptor and the seed substrate, the sub-susceptor being not reactive with the seed substrate, with a gap provided between the seed substrate and the sub-susceptor.

## Description

### TECHNICAL FIELD

The present invention relates to a method and apparatus for fabricating a freestanding GaN substrate and, more particularly, to a method and apparatus for fabricating a freestanding GaN substrate, which can restrict abnormal growth of GaN crystals on the surrounding of a substrate-forming portion.

### BACKGROUND ART

GaN-based compound semiconductors are used in electronic devices such as light-emitting diodes (LEDs), laser diodes (LDs), etc.

Progress, especially, in the application to illumination of white LEDs in which GaN LED chips and phosphors are combined has recently been accelerated. The white LEDs have lower power consumption and longer lifetime than those of incandescent lights, they draw public attention as a substitute for the incandescent lights. Accordingly, there is a need to fabricate such GaN-based compound semiconductors in an inexpensive, massive manner.

GaN freestanding substrates are fabricated by a variety of methods (e.g. ultra high temperature and pressure method, flux method, vapor phase deposition method, etc.). Particularly, Hydride Vapor Phase Epitaxy method (HVPE) has been technically established and it is being practically used for fabricating many kinds of chips.

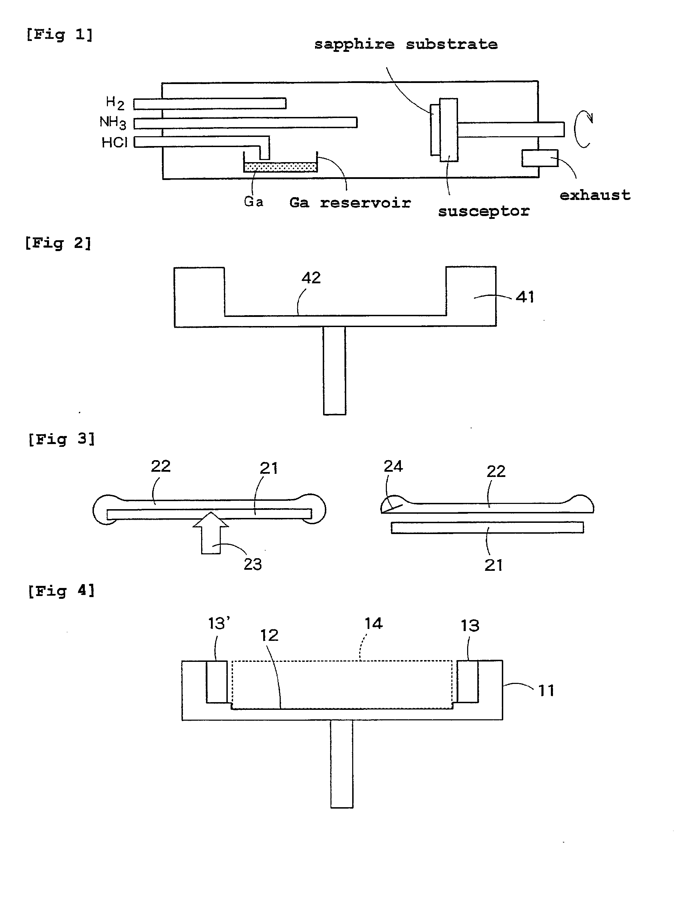

Now the HVPE will be summarized with reference to FIG. 1. The HVPE is a method in which gallium chloride (GaCl) gas and ammonia gas (NH3) as GaN source are supplied so as to precipitate GaN on a substrate. Hydrogen gas is introduced as a carrier gas into the whole of a reaction tube. Gallium chloride is produced by spraying hydrogen chloride gas to the surface of fused gallium metal. Here, in the reaction tube, GaCl gas is produced (or synthesized) by the following chemical reaction.

2Ga + 2HCl → 2GaCl + H₂

On a seed substrate held on in a susceptor, Gallium nitride is produced by the reaction between GaCl and ammonia as expressed by following chemical reaction. Then the crystal of gallium nitride is grown on a seed substrate held on a susceptor. GaCl + NH₃ → GaN + HCl + H₂
As a side reaction, following chemical reaction occurs to produce ammonium chloride.

HCl + NH₃ → NH₄Cl

The susceptor which is generally used with the HVPE apparatus shown in FIG. 1 and shown in FIG. 2 which showed a conventional one. The susceptor 41 shown in FIG. 2 includes a pocket section 42 for holding the seed substrate therein. When the source gas reaches the upper portion of the seed substrate held in the pocket section 42, GaN is precipitated on the surface of the seed substrate by chemical reaction, and the GaN is grown thereon.

Now the growth of freestanding GaN substrate using HVPE will be explained with reference to FIG. 3 (prior art). As shown in FIG. 3 (a), after a thick GaN layer 22 was grown on a sapphire seed substrate 21, the sapphire seed substrate is lifted off from the GaN layer. Then, the GaN layer 22 is lifted off as a freestanding GaN substrate. The lift-off is conventionally carried out by a method called a laser lift off method. In this method, the lift-off of GaN from said sapphire seed substrate is carried out in such a manner that a laser beam 23 having a wavelength that is not absorbed in the sapphire seed substrate, but absorbed in the GaN layer, thereby acting as a heat source, is exposed towards the sapphire seed substrate as shown in FIG. 3 (a) so as to fuse a thin film of GaN in contact with the seed substrate. Thereby GaN freestanding substrate is separated as shown in FIG. 3 (b).

In the meantime, in the growth of freestanding GaN substrate using the HVPE, it is indicated that as shown in FIG. 3 (a), the GaN layer around the seed substrate is abnormally grown so that the GaN layer on the side and bottom areas also becomes too thick (crowning or poor morphology). Consequently, because of stress occurring on the abnormally grown portion, as shown in FIG. 3 (b), a crack 24 occurs. So, the freestanding GaN layer to be subsequently cracked. It is known that this phenomenon is usual in growth using the HVPE.

In conjunction with this problem, Patent Document 1 (Japanese unexamined patent publication No. 2009-91163) proposed a method of fabricating a single crystal GaN, which includes forming a seed layer on a substrate, forming a mask on the seed layer, and growing a single crystal GaN on the seed layer. Also, Patent Document 2 (Japanese unexamined patent publication No. 2007-5658) proposed a method of wet-etching inside and outside crowns. Further, while a method of forming an intermediate layer or a buffer layer on a substrate has been also proposed. These processes do not effectively restrict the crowning effect.

Thus, a need still exists to develop a method and apparatus for fabricating a freestanding GaN substrate in an inexpensive, massive manner by which abnormal growth of GaN on the side and bottom of the seed substrate can be restricted and thereby effectively preventing the freestanding GaN substrate from being damaged and cracked.

Patent Document 1: Japanese unexamined patent publication No. 2009-91163
Patent Document 2: Japanese unexamined patent publication No. 2007-5658

### DISCLOSURE OF THE INVENTION

The inventors found that the abnormal growth of GaN crystals around edge of a seed substrate could be effectively restricted by adapting a susceptor in which a sub-susceptor which does not react with the seed substrate is provided between the susceptor and the seed substrate, with a gap created between the seed substrate and the sub-susceptor. The present invention is based on these findings.

Therefore, a first aspect of the present invention proposes a method of fabricating a freestanding GaN substrate using vapor phase deposition. This method comprising:
supplying a source gas of a GaN crystal to a susceptor in which a seed substrate different from GaN is disposed, and
restricting the GaN crystal around opposite ends of the seed substrate disposed in the susceptor from being abnormally grown and vapor phase growing the freestanding GaN substrate,
wherein the susceptor comprises a pocket section in which the seed substrate is fixedly held, and a sub-susceptor between the susceptor and the seed substrate, the sub-susceptor being not reactive with the seed substrate, with a gap created between the seed substrate and sub-susceptor, thereby restricting the abnormal growth of the GaN crystal around the edge of the seed substrate.

A second aspect of the present invention proposes an apparatus for fabricating a freestanding GaN substrate using vapor phase deposition, the apparatus comprising:
supply sections supplying a source gas of a GaN crystal and a carrier gas, respectively,
a susceptor holding therein a seed substrate and allowing the source gas to react each other, and thereby vapor phase growing the freestanding GaN substrate, and
an exhaust unit,
wherein the susceptor comprise a pocket section in which the seed substrate is fixedly held, and a sub-susceptor between the susceptor and the seed substrate, the sub-susceptor being not reactive with the seed substrate, with a gap created between the seed substrate and sub-susceptor, thereby restricting the abnormal growth of the GaN crystal around the edge of the seed substrate.

A third aspect of the present invention proposes a method of restricting the abnormal growth of a GaN crystal using vapor phase deposition, the method comprising:
Vapor phase growing the GaN crystal in a susceptor in which a seed substrate is held, using the vapor phase deposition,
wherein the method uses the susceptor, which comprise a pocket section in which the seed substrate is fixedly held, and a sub-susceptor between the susceptor and the seed substrate, the sub-susceptor being not reactive with the seed substrate, with a gap created between the seed substrate and sub-susceptor, to restrict the abnormal growth of the GaN crystal around the edge of the seed substrate.

A fourth aspect of the present invention proposes a susceptor for restricting the abnormal growth of a GaN crystal, wherein the susceptor is used in a method and apparatus for fabricating a freestanding GaN substrate using vapor phase deposition and a method of restricting the abnormal growth of the GaN crystal, the susceptor comprising:
a seed substrate,
a pocket section in which the seed substrate is fixedly held, and
a sub-susceptor between the susceptor and the seed substrate, the sub-susceptor being not reactive with the seed substrate, with a gap created between the seed substrate and sub-susceptor, thereby restricting the abnormal growth of the GaN crystal around the edge of the seed substrate.

The present invention has effects of restricting the abnormal growth of the GaN crystal around the edge of the seed substrate and therefore forming a smooth freestanding GaN substrate while preventing the freestanding GaN substrate from being damaged and cracked when separating process of the same.

### EMBODIMENTS OF THE INVENTION

### 1. SUSCEPTOR

The present invention (a fabricating method, an abnormal growth suppressing method, and a susceptor) comprises a seed substrate, a pocket section in which the seed substrate is fixedly held, and a sub-susceptor between the susceptor and the seed substrate, the sub-susceptor being not reactive with the seed substrate, with a gap created between the seed substrate and sub-susceptor, thereby suppressing the abnormal growth of a GaN crystal around the opposite ends of the seed substrate.

The susceptor of the invention will now be explained with reference to FIG. 4. FIG. 4 is a schematic cross-sectional view showing an example of a susceptor 11 according to the present invention. In the susceptor, a seed substrate 14 is fixed into a pocket section 12, and around edge of the seed substrate 14, a sub-susceptor 13, which is composed of a substrate material (quartz glass or the like), being not reactive with the seed substrate 14, is fitted between the susceptor 11 and the seed substrate 14.

### SUB-SUSCEPTOR

The present invention adopts the sub-susceptor, preferably made of the same material as the seed substrate. On the surface of the sub-susceptor which is exposed to source gas, crystal growth (selective growth) of GaN is suppressed and ,as a result, the abnormal growth of GaN crystal around edge of the seed substrate is suppressed. Further, since the source gas is mostly consumed on the surfaces of the seed substrate and sub-susceptor, the flow of source gas is effectively prevent from straying into the side or bottom of the seed substrate, thereby also suppressing the abnormal growth of GaN crystal around the side and bottom of the seed substrate.

### GAP / THICKNESS

If the GaN crystal is made thicker, the seed substrate and the sub-susceptor should not be not fit directly each other and it is preferred to make a gap between said substrate and said sub-susceptor. With the gap (between 14 and 13, 13' in FIG. 4), it is possible to effectively prevent a GaN crystal layer growing on the seed substrate and a GaN crystal layer growing on the sub-susceptor from being contacted, so that a freestanding GaN crystal substrate (can be used as an equivalent for the GaN crystal layer) can be easily lifted off from the seed substrate. As a result, it is possible in the lift-off process to prevent breakage of the GaN crystal layer caused due to occurrence of new stress or the like.

To determine width of said gap, it is important to consider a concentration or other condition of source material. When taking the concentration of source material into consideration, a speed of lateral crystal growth at the seed substrate and sub-susceptor amounts to half of a speed of the vertical growth to the seed substrate. As such, according to an aspect of the present invention, the gap between the seed substrate and the sub-susceptor may preferably have the same size as the thickness of the freestanding GaN substrate. In addition, the gap between the seed substrate and the sub-susceptor may preferably have the size having a range more than 0, but not more than 2 mm, particularly with a minimum of 0.2 mm or more and a maximum of 2 mm or less. With the gap being within the range, it is possible to suppress said abnormal growth of GaN crystal.

### MATERIAL

In the present invention, the sub-susceptor may be made of the same material as the seed substrate. Preferably, the seed substrate and the sub-susceptor may be composed of sapphire. However, according to the present invention, the sub-susceptor may be composed of a material different from the seed substrate, preferably a poly or single crystalline material. This is due to the fact that "selective growth" that accelerates the abnormal growth is essentially difficult to occur on an amorphous material, but is ready to occur on the poly or single-crystalline material. Thus, if the seed substrate is surrounded by the poly or single-crystalline material different from that of the seed substrate, it is possible to obtain the similar effect as in the case of the seed substrate being surrounded by the same material as that of the seed substrate. According to a preferred embodiment of the present invention, the sub-susceptor may use single or poly-crystalline silicon carbide, or single or poly-crystalline aluminum nitride. In this case, the seed substrate may be made of a different material from said sub-susceptor, preferably sapphire.

The sub-susceptor may be composed of a material that is not reactive with the seed substrate at the growth temperature of GaN crystal, preferably that is not decomposed at temperature that a GaN crystal is grown. Thus, it is preferable that the sub-susceptor is made of a material that is the same as or different (different kind of poly or single-crystalline material) from that of the seed substrate, and that is a stable and not reactive or decomposable at temperature of at least room temperature (25°C) or more, preferably 1050 °C or more (a preferred temperature at which a GaN crystal layer can be grown), more preferably up to approximately 1200 °C.

Any shape of the sub-susceptor is possible, however it is preferable that they have a shape a cylinder, a disc, a ring, or the like.

### THICKNESS OF FREESTANDING GaN SUBSTRATE (GaN CRYSTAL LAYER)

When the freestanding GaN substrate is manufactured by lift-off of sapphire seed substrate, considering the subsequent steps the thickness of freestanding GaN substrate is-preferably in the range of 0.25 mm or more, more preferably 0.4 mm or more. On the other hand, to sufficiently suppress the abnormal growth, the thickness of the freestanding GaN substrate may preferably have a range of 2 mm or less, more preferably 1.5 mm or less.
In the present invention, when taking vapor phase deposition of the GaN crystal into consideration, the gap between the seed substrate and sub-susceptor and the thickness of the freestanding GaN substrate may preferably be of a range that is more than 0 mm, but not more than 2 mm, respectively.

### VAPOR DEPOSITION

The present invention can use any kind of vapor phase deposition (physical, chemical), chemical vapor deposition (CVD) is more preferable. In the CVD method, source gas is supplied onto a heated target substrate in a reaction tube so that a thin film is formed by chemical reaction occurring on the surface of the target substrate or in the vapor phase near said substrate. The CVD used in the present invention may include thermal CVD, catalytic CVD, plasma CVD, organometal CVD, hydride vapor phase epitaxy (HVPE), or the like. Preferably, the HVPE is used. The HVPE was already explained before.

### 2. FABRICATING METHOD

The present invention can provide a method of fabricating a freestanding GaN substrate using a vapor phase deposition method and a susceptor characteristic to the present invention. This fabricating method can be applied in a fabricating method (apparatus) which comprise an additional (element)process of etching or polishing the freestanding GaN substrate obtained by naturally(spontaneously) or artificially separating the freestanding GaN substrate from seed substrate.

Further, according to an another embodiment of the present invention, the present invention can be used in a method (or apparatus) of fabricating a freestanding GaN substrate, which comprises a process (element) of depositing GaN layer by vapor phase depositing process after forming an intermediate layer such as a buffer layer, a metal layer, a lift-off layer, etc. on a seed substrate.

According to a preferred embodiment of the present invention, a method of spontaneously forming the intermediate layer (lift-off layer) when carrying out the growth of a GaN crystal may comprise:
forming aluminum nitride of proper size and density on the surface of a sapphire seed substrate by exposing the sapphire substrate to ammonia gas at high temperature of 1050°C or more,
forming a first layer consisting of GaN dots and a ift-off material on the surface of the seed substrate at low temperature,
growing a second layer consisting of a GaN crystal layer on the first layer at low temperature of 500∼600°C,
vaporizing and removing the lift-off material as well as growing a third layer consisting of a GaN crystal layer on the second layer at high temperature of 1000°C or more, and
in the process of lowering the temperature to room temperature, concentration of stress, which occurs due to a difference of coefficient of thermal expansion between the seed substrate and the GaN layer, upon GaN dots to render only the GaN dots to be broken, thereby spontaneously lift off the GaN crystal layer constituting the second and third layers from the sapphire substrate and then polishing the surface and bottom of the GaN crystal layer, obtaining the freestanding GaN substrate.

Thus, the present invention can be used in the process of the fabricating method of the freestanding GaN substrate in which the lift off layer is formed between the seed substrate and the freestanding GaN layer. That is, the susceptor according to the present invention can be used in a series of processes from the vapor deposition of the GaN crystal to the lift-off of the freestanding GaN substrate from the seed substrate. As a result, breakage of the freestanding GaN substrate can be prevented, thereby considerably improving fabrication yield.

### 3. FABRICATING APPARATUS

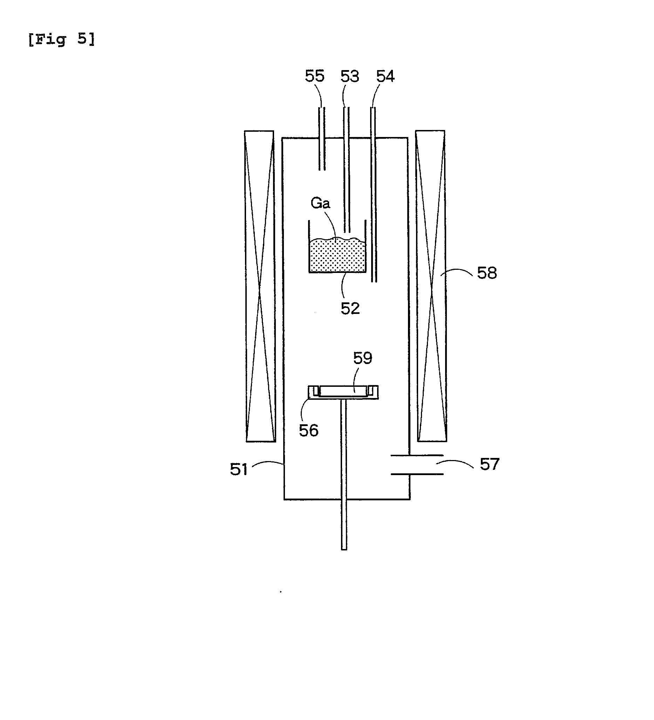

A fabricating apparatus according to the present invention will now be explained with reference to FIG. 5. The fabricating apparatus can be explained in conjunction with the susceptor and the fabricating method which prevent the GaN crystal from being abnormally grown in the process of CVD.

FIG. 5 shows an exemplary HVPE apparatus having the susceptor according to the present invention. The HVPE apparatus comprises a reaction tube 51 and an electric furnace 58 capable of partially controlling the temperature of the entire reaction tube.
The quartz reaction tube 51 comprises a Ga reservoir 52, a HCl gas supply 53 which supplies HCl gas as source gas to the Ga reservoir, a NH3 gas supply 54, a carrier gas (H2) supply 55, a susceptor which holds a seed substrate 59 therein and rotates, and a gas exhaust unit 57. Since the fabricating apparatus comprises the characteristic susceptor 56, it is possible to suppress the abnormal growth of a GaN crystal around opposite ends of the seed substrate.

### 4. USE

The fabricating method, the fabricating apparatus, the suppressing method and the like of the present invention can be used in fabrication of GaN for use in illumination of a white LED in which GaN based LED chips and phosphors are combined.

### BRIEF DESCRIPTION OF THE DRAWINGS

FIG. 1 is a schematic cross-sectional view of a HVPE apparatus.
FIG. 2 is a schematic cross-sectional view showing a conventional susceptor.
FIG. 3 is a schematic cross-sectional view explaining a crowning phenomenon in GaN freestanding growth according to the related art.
FIG. 4 is a schematic cross-sectional view showing a susceptor having a sub-susceptor according to the present invention.
FIG. 5 is a view showing an exemplary HVPE apparatus having a susceptor according to the present invention.

### APPLICATION OF THE PRESENT INVENTION

A explanation will be made of effects upon restriction of abnormal growth of GaN crystals, particularly around edge of a seed substrate and upon lift-off of GaN from the seed substrate when a GaN layer is grown in a HVPE apparatus according to an embodiment of the present invention. In the embodiment, the GaN layer is grown using the HVPE apparatus shown in FIG. 5.

### FIRST EMBODIMENT

A first embodiment relates to crystal growth of GaN using a susceptor shown in FIG. 4, in which a sapphire seed substrate and a sapphire ring as a subsusceptor are mounted, with a gap of 100 *µ*m created between the sapphire seed substrate and the subsusceptor. The depth of a pocket section was 430 *µ*m, which is the same as that of the seed substrate.

The sapphire seed substrate of 430 *µ*m thickness was fixed to a susceptor, and a quartz Ga reservoir was disposed at a certain position in a HVPE apparatus (reactor) while high purity Ga was being placed in the Ga reservoir. The sapphire seed substrate was a 2 inch diameter circular substrate having a plane shifted at 0.25° in a (1, 0, -1, 0) direction from (0, 0, 0, 1) c(Ga) plane. The susceptor is rotated about a center axis. In the following, a flow rate of gas was expressed by standard units, SLM and SCCM.

N2 gas was supplied into the reactor so as to substitute air in the reactor, and then N2 gas was supplied at 1 SLM. Subsequently, heating was carried out using a heater. A heating method was a hot wall method that heats an outer wall of the reactor using the heater. In the hot wall method, a thermocouple was displaced around outside of the reactor close to the sapphire seed substrate to measure temperature, and the measured temperature was determined as the temperature of the sapphire seed substrate. This arrangement is implemented because temperatures of the outside and inside of the quartz reactor are substantially the same each other.

Subsequently, after it was checked that the substrate temperature was elevated to 1080 °C and stabilized, ammonia (NH₃) gas and hydrogen (N₂) gas were introduced into the reactor at 2 SLM and 5 SLM, respectively, and the temperature of the sapphire seed substrate was elevated to 1080 °C and held for 30 min. With this process, the surface of the sapphire seed substrate was nitrified to partially form AlN.

Subsequently, the temperature of the sapphire seed substrate was lowered to 500 °C, but the ammonia gas and hydrogen gas were still held at that flow rates. After it was checked that the temperature of the sapphire seed substrate was lowered to 500 °C and stabilized, hydrogen chloride (HCl) gas was introduced at 80 SCCM into the Ga reservoir which was held at 450 °C. In this process, a layer consisting of GaN dots and ammonium chloride is grown, and in this embodiment, the thickness of the grown layer was set to 800 nm.

The sapphire seed substrate having thereon the layer consisting of GaN dots and ammonium chloride was then heated to temperature of 500 to 600 °C. The flow rates of ammonia gas, hydrogen gas, and hydrogen chloride gas, and the temperature of the Ga reservoir were still held. When the temperature of the sapphire seed substrate exceeds 520 °C, growth of ammonium chloride is suppressed, and the growth rate of GaN increases, so that with the growth of GaN occurring from GaN dots, GaN is diffused in a parallel direction with the substrate surface, resulting in the formation of a GaN layer. This layer is called a low temperature buffer layer. Here, the thickness of the low temperature buffer layer was set to 180 nm.

The sapphire seed substrate was further heated to 1040 °C. In this temperature range, ammonium chloride is completely decomposed by a heat treatment effect, and GaN layer is grown at high temperature. Here, unlike the low temperature GaN buffer layer, GaN grown at high temperature consists of a high quality GaN layer with less defects.

After GaN was grown up to the thickness of approximately 400 *µ*m, supply of HCl gas was interrupted, and temperature of sapphire seed substrate was lowered. When the temperature of the sapphire seed substrate was lowered to 500 °C, instead of supplying ammonia gas and hydrogen gas, nitrogen gas was supplied at 1 SLM, and additionally the temperature was cooled to room temperature. When the substrate was unloaded after having been cooled to room temperature, the GaN layer was not broken, but naturally lifted off from the sapphire seed substrate. Yield of natural lift-off was 83%.

Here, the thickness of the actually grown GaN layer was 406 *µ*m at the center of the sapphire seed substrate. At the edge portion of the substrate, namely 1 mm inner portion from the edge of the substrate, was the thickest portion, and the thickness of the GaN layer was 418 *µ*m. By comparing these values of thickness at both portion, it is clear that abnormal growth of edge portion of the substrate was remarkably suppressed than those thickness values of the substrate grown by the HVPE apparatus having a conventional susceptor. The growth of GaN on the side or bottom of the substrate was also mostly restricted.

Natural lift-off of the GaN substrate without breakage is occurred because the abnormal growth of GaN crystals around the side and bottom of the seed substrate was suppressed, which was caused by using the susceptor which surrounds the sapphire seed substrate with a sapphire ring of a sub-susceptor. GaN grown on the sub-susceptor was naturally lifted off and maintenance of the HVPE apparatus became simplified.

### SECOND EMBODIMENT

The second embodiment relates to crystal growth of GaN using the sapphire seed substrate and the sub-susceptor (sapphire ring) of the first embodiment, with a gap of 600 *µ*m created between the sapphire seed substrate and the subsusceptor. The depth of a pocket section was 430 *µ*m, which is the same as that of the seed substrate.
The sapphire seed substrate and the growth process of the GaN layer that were used are the same as in the first embodiment. Here, actually grown thickness of the GaN layer was 410 *µ*m at the center of the sapphire seed substrate. On the edge portion of the substrate, a 1 mm inner portion from the edge of the substrate was the thickest portion, and the grown thickness of the GaN layer was 422 *µ*m. Similar to the first embodiment, it could be seen that the abnormal growth of GaN crystals around the edge of seed substrate was suppressed.

Further, when the substrate was unloaded after having been cooled to room temperature (approximately 25 °C), both GaN layers grown on the seed substrate and the sapphire ring of subsusceptor in the susceptor were not combined with each other. As the result, the GaN layer grown on the sapphire seed substrate was not broken, but naturally lifted off from the sapphire seed substrate. Yield of natural lift-off without breakage was 96%.

From a result of the second embodiment, it was understood that with proper adjustment of a gap between the sapphire seed substrate and the sapphire of the sub-susceptor, both GaN layers grown on the seed substrate and the sapphire ring of subsusceptor were not combined. As a result, it was understood that the effects of the GaN crystals being sufficiently grown and of the GaN layer grown on the sapphire seed substrate being naturally lifted from the sapphire substrate without being broken could be further improved.

### THIRD EMBODIMENT

The third embodiment is the embodiment in which as a sub-susceptor in the susceptor shown in FIG. 1 in the first embodiment, the sapphire ring was substituted by silicon carbide (SiC) having a poly-crystalline structure that is stable in a range from room temperature up to 1200 °C is used.

In the similar growth process as shown in the first and second embodiments, a freestanding GaN substrate layer was grown on a sapphire seed substrate. Here, as in the second embodiment, the gap between the sapphire seed substrate and the silicon carbide ring of the subsusceptor was set to 600 *µ*m. The depth of a pocket section was 430 *µ*m, which is the same as that of the seed substrate.

The thickness of the actually grown GaN layer was 402 *µ*m at the center of the sapphire seed substrate. At the edge portion of the substrate, a 1 mm inner portion from the edge was the thickest portion, and the thickness of the grown GaN layer was 418 *µ*m. As a result of using the silicon carbide ring as the sub-susceptor, it could be seen that the abnormal growth of GaN crystals around the edge of sapphire seed substrate was suppressed.

Further, when the substrate was unloaded after having been cooled to room temperature (approximately 25 °C), the GaN layer grown on the sapphire seed substrate and GaN layer grown on the silicon carbide ring as sub-susceptor were not combined with each other. So, the GaN layer grown on the sapphire seed substrate was not broken, but naturally lifted off from the sapphire seed substrate. Yield of natural lift-off without breakage was approximately 92%.

### FOURTH EMBODIMENT

The fourth embodiment relates to the GaN crystal growth using the susceptor shown in FIG. 1, with a gap between the sapphire seed substrate and the sub-susceptor (sapphire ring) set to 600 *µ*m as in the second embodiment. The depth of a pocket section was 430 *µ*m, which is the almost same as that of the seed substrate.

In the HVPE apparatus using this susceptor, the sapphire seed substrate and the sub-susceptor (sapphire ring) were loaded in the susceptor, nitrogen (N₂) gas was supplied into the reactor so as to substitute air in the reactor, and then nitrogen (N₂) gas was supplied at 1 SLM. Then, inside of the reactor was heated using a heater. Subsequently, after it was checked that temperature of the sapphire seed substrate was elevated to 1080 °C and after said temperature stabilized, ammonia (NH₃) gas and hydrogen (N₂) gas were introduced into the reactor at 2 SLM and 5 SLM, respectively, and the temperature of the sapphire seed substrate was held for 30 min.

Subsequently, the temperature of the sapphire seed substrate was lowered to 1050 °C, but the ammonia gas and hydrogen gas were still held at that flow rates. After it was checked that the temperature of the substrate was lowered to 1050 °C and stabilized, hydrogen chloride (HCl) gas was introduced at 80 SCCM into the Ga reservoir which was held at 450 °C. In this process, a GaN layer is grown directly on the sapphire seed substrate without interposing a lift-off layer or the like. The grown thickness of a GaN layer was set to approximately 400 *µ*m.

After the growth have been completed, the reactor was unloaded after being checked that its temperature was slowly lowered to room temperature such that the grown GaN layer was not broken. Here, it was understood that the GaN layer on the sapphire seed substrate and the GaN layer partially grown on the sub-susceptor were not combined together.

The measured thickness of the grown GaN layer was 398 *µ*m at the center of the sapphire seed substrate. Around the edge of the sapphire seed substrate, at a 1 mm inner portion from the edge ,which was the thickest portion, the thickness of the GaN layer was 411 *µ*m. As a result of using the susceptor having the structure in which the surrounding of the seed substrate was covered with the same material as the seed substrate, it could be seen that the abnormal growth around the substrate was considerably suppressed.

### COMPARATIVE EMBODIMENT

In the susceptor shown in FIG. 4, the sapphire seed substrate was surrounded by a quartz ring, and a GaN layer was grown using the same growth process as in the first embodiment. The grown thickness of GaN was approximately 385 *µ*m. a 1 mm inner portion from the edge of the substrate was the thickest portion and its thickness was 539 *µ*m. Compared to the growth around the substrate using the HVPE apparatus having a conventional susceptor, the abnormal growth around the seed substrate was not suppressed. Further, the growth of GaN on the side and bottom of the substrate was observed.
While in this growth process, the lift-off layer was interposed so that the freestanding GaN substrate layer was automatically lifted off without being broken, the yield of lift-off without breakage was 68%. Thus, it had no effect upon occurrence of breakage that is caused by the abnormal growth of the circumference of the substrate.

## Claims

1. A method of fabricating a freestanding GaN substrate using vapor phase deposition comprising;
supplying a source gas of a GaN crystal to a susceptor in which a seed substrate different from GaN is disposed; and
suppressing the GaN crystal around edge of the seed substrate disposed in the susceptor from being abnormally grown and vapor phase growing the freestanding GaN substrate,
wherein the susceptor includes a pocket section in which the seed substrate is fixedly held, and a sub-susceptor between the susceptor and the seed substrate, the sub-susceptor being not reactive with the seed substrate, with a gap created between the seed substrate and sub-susceptor, thereby suppressing the abnormal growth of the GaN crystal around the edge of the seed substrate.

2. The method according to claim 1, wherein the gap has the same size as the thickness of the freestanding GaN substrate.

3. The method according to any one of claim 1 or 2, wherein the size of the gap and the thickness of the freestanding GaN substrate are larger than 0 mm, but not more than 2 mm, respectively.

4. The method according to any one of claims 1-3, wherein the sub-susceptor is made from sapphire, single or poly-crystal silicon carbide, or single or poly-crystal aluminum nitride.

5. The method according to any one of claims 1-4,wherei sub-susceptor is not decomposed at temperature of at least room temperature or more, but not less than 1200 °C.

6. The method according to any one of claims 1-5, wherein the vapor phase deposition is hydride vapor phase epitaxy (HVPE).

7. An apparatus for fabricating a freestanding GaN substrate using vapor phase deposition comprising;
supply sections supplying a source gas of a GaN crustal and a carrier gas, respectively;
a susceptor holding therein a seed substrate and allowing the source gas to react with the seed substrate, thereby vapor-growing the freestanding GaN substrate; and
an exhaust unit,
wherein the susceptor includes a pocket section in which the seed substrate is fixedly held, and a sub-susceptor between the susceptor and the seed substrate, the sub-susceptor being not reactive with the seed substrate, with a gap created between the seed substrate and sub-susceptor, thereby suppressing the abnormal growth of the GaN crystal around the edge of the seed substrate.

8. A method of suppressing the abnormal growth of a GaN crystal using vapor phase deposition comprising;
vapor-growing the GaN crystal in a susceptor in which a seed substrate is held, using the vapor phase deposition;
wherein the method uses the susceptor, which includes a pocket section in which the seed substrate is fixedly held, and a sub-susceptor between the susceptor and the seed substrate, the sub-susceptor being not reactive with the seed substrate, with a gap created between the seed substrate and sub-susceptor, to suppress the abnormal growth of the GaN crystal around the edge of the seed substrate.

9. A susceptor for suppressing the abnormal growth of a GaN crystal, wherein the susceptor is used in a method and apparatus for fabricating a freestanding GaN substrate using vapor phase deposition and a method of suppressing the abnormal growth of the GaN crystal comprising;
a seed substrate;
a pocket section in which the seed substrate is fixedly held; and
a sub-susceptor between the susceptor and the seed substrate, the sub-susceptor being not reactive with the seed substrate, with a gap created between the seed substrate and sub-susceptor, thereby suppressing the abnormal growth of the GaN crystal around the opposite ends of the seed substrate.
